# EUROPEAN PATENT APPLICATION

(11) **EP 4 773 178 A1**
(43) Date of publication of application: **08.07.2026**
(21) Application number: 24859273.5
(22) Date of filing: 25.07.2024
(51) Int. Cl.: H01L 21/683, C04B 35/111, C04B 41/80, H02N 13/00

(54) **ELECTROSTATIC CHUCK AND METHOD FOR PRODUCING ELECTROSTATIC CHUCK**

(30) Priority: 29.08.2023 JP 2023139253
(71) Applicant: Tokyo Electron Limited, Tokyo 107-6325 (JP)
(72) Inventor: KAWABATA, Atsushi, Kurokawa-gun, Miyagi 981-3629 (JP); SATO, Masanori, Kurokawa-gun, Miyagi 981-3629 (JP); TSUNAMOTO, Tetsu, Kurokawa-gun, Miyagi 981-3629 (JP)
(74) Representative: Hoffmann Eitle
(86) International application number: PCT/JP2024/026671
(87) International publication number: WO 2025/047231

(57) **Abstract**

A technique reduces scratches on the back surface of a substrate held on an electrostatic chuck. An electrostatic chuck for holding a substrate includes a dielectric member, and an electrode in the dielectric member. The dielectric member includes an upper surface, and a plurality of projections projecting upward from the upper surface. The plurality of projections support a substrate. Each of the plurality of projections includes a crystalline base and an amorphous surface layer on the crystalline base.

## Description

### FIELD

Exemplary embodiments of the disclosure relate to an electrostatic chuck and a method for manufacturing an electrostatic chuck.

### BACKGROUND

Patent Literature 1 describes a technique for an electrostatic chuck (ESC) including multiple protrusions on its surface.

### CITATION LIST

### PATENT LITERATURE

Patent Literature 1: Japanese Unexamined Patent Application Publication No. 2022-129632

### BRIEF SUMMARY

### TECHNICAL PROBLEM

One or more aspects of the disclosure are directed to a technique for reducing scratches on the back surface of a substrate held on an electrostatic chuck.

### SOLUTION TO PROBLEM

An electrostatic chuck according to one exemplary embodiment of the disclosure is an electrostatic chuck for holding a substrate. The electrostatic chuck includes a dielectric member, and an electrode in the dielectric member. The dielectric member includes an upper surface, and a plurality of projections projecting upward from the upper surface. The plurality of projections support a substrate. Each of the plurality of projections includes a crystalline base and an amorphous surface layer on the crystalline base.

### ADVANTAGEOUS EFFECTS

The technique according to one exemplary embodiment of the disclosure reduces scratches on the back surface of a substrate held on the electrostatic chuck.

### BRIEF DESCRIPTION OF DRAWINGS

FIG. 1 is a diagram of a plasma processing system with an example structure.
FIG. 2 is a diagram of a plasma processing apparatus with an example structure.
FIG. 3 is a plan view of an electrostatic chuck (ESC) with an example structure.
FIG. 4 is a diagram of an ESC with an example structure.
FIG. 5 is a diagram of a projection with an example structure.
FIG. 6 is a diagram of a projection showing an example structure.
FIG. 7 is a flowchart of an example method for manufacturing an ESC.
FIG. 8 is a diagram describing an example process for forming a polished surface on a surface layer of a projection.
FIG. 9 is a diagram describing an example process for forming a polished surface on surface layers of the side surface and the upper surface of the projection.
FIG. 10 is a flowchart of another example method for manufacturing an ESC.
FIG. 11 is a diagram describing an example process for exposing, on a side surface of a projection, a boundary between a surface layer and a base of the projection.
FIG. 12 is a diagram describing an example process for forming the projection by blasting.
FIG. 13 is a diagram describing an example process for forming a surface layer on the side surface of the projection during or after forming the projection by laser processing.
FIG. 14 is a diagram describing an example process for forming a surface layer on an upper surface of the projection after forming the surface layer on the side surface of the projection.
FIG. 15 is a diagram describing an example process for forming a surface layer on a seal band.
FIG. 16 is a diagram describing an example process for forming a surface layer on grooves surrounding the projection and the seal band.

### DETAILED DESCRIPTION

One or more embodiments of the disclosure will be described below.

An electrostatic chuck according to one exemplary embodiment is an electrostatic chuck for holding a substrate. The electrostatic chuck includes a dielectric member, and an electrode in the dielectric member. The dielectric member includes an upper surface, and a plurality of projections projecting upward from the upper surface. The plurality of projections support a substrate. Each of the plurality of projections includes a crystalline base and an amorphous surface layer on the crystalline base.

In one exemplary embodiment, the amorphous surface layer has a thickness in a range of 0.1 to 20 µm.

In one exemplary embodiment, the amorphous surface layer has a thermal conductivity equal to or lower than a thermal conductivity of the crystalline base.

In one exemplary embodiment, the amorphous surface layer contains amorphous alumina.

In one exemplary embodiment, the plurality of projections have marks from laser beam application.

A method according to one exemplary embodiment is a method for manufacturing an electrostatic chuck. The method includes (a) forming a plurality of projections being crystalline and projecting upward from an upper surface of a dielectric member, and (b) forming an amorphous surface layer on each of the plurality of projections by applying a laser beam to the plurality of projections.

In one exemplary embodiment, the amorphous surface layer has a thickness in a range of 0.1 to 20 µm.

In one exemplary embodiment, the amorphous surface layer has a thermal conductivity equal to or lower than a thermal conductivity of a base included in each of the plurality of projections.

In one exemplary embodiment, the amorphous surface layer contains amorphous alumina.

A method according to one exemplary embodiment is a method for manufacturing an electrostatic chuck. The method includes (a) forming, on an upper surface of a dielectric member included in an electrostatic chuck used in plasma processing, a plurality of projections being crystalline and projecting upward from the upper surface, and (b) forming an amorphous surface layer on each of the plurality of projections by applying a laser beam to the plurality of projections.

In one exemplary embodiment, the amorphous surface layer has a thickness in a range of 0.1 to 20 µm.

In one exemplary embodiment, the amorphous surface layer has a thermal conductivity equal to or lower than a thermal conductivity of a base included in each of the plurality of projections.

In one exemplary embodiment, the amorphous surface layer contains amorphous alumina.

In one exemplary embodiment, the amorphous surface layer includes a polished surface with a surface roughness Ra less than or equal to 0.05 µm.

In one exemplary embodiment, each of the plurality of projections includes an upper surface and a side surface, and a boundary between the crystalline base and the amorphous surface layer is exposed on the side surface of each of the plurality of projections without being exposed on the upper surface of the projection.

In one exemplary embodiment, the amorphous surface layer has a depth in a range of 100 to 500 nm from a surface and a hardness in a range of 22 to 27 GPa when measured with a nanoindenter method.

In one exemplary embodiment, each of the plurality of projections includes a seal band configured to support an outer periphery of the substrate.

In one exemplary embodiment, the dielectric member further includes grooves surrounding respective projections of the plurality of projections, and each of the grooves includes a crystalline groove base and an amorphous groove surface layer on the crystalline groove base.

In one exemplary embodiment, the method further includes (c) polishing the amorphous surface layer.

In one exemplary embodiment, (a) includes forming the plurality of projections by laser processing, and (b) includes forming the amorphous surface layer on a side surface of each of the plurality of projections and subsequently the amorphous surface layer on an upper surface of each of the plurality of projections by applying a laser beam.

In one exemplary embodiment, (a) includes forming the plurality of projections by blasting, and (b) includes forming the amorphous surface layer on an upper surface of each of the plurality of projections by applying a laser beam.

One or more embodiments of the disclosure will now be described with reference to the drawings. In the drawings, like reference numerals denote like or corresponding components. Such components will not be described repeatedly. Unless otherwise specified, the positional relationships shown in the drawings are used to describe the vertical, lateral, and other positions. The drawings are not drawn to scale relative to the actual ratio of each component, and the actual ratio is not limited to the ratio in the drawings.

### Example Structure of Plasma Processing System

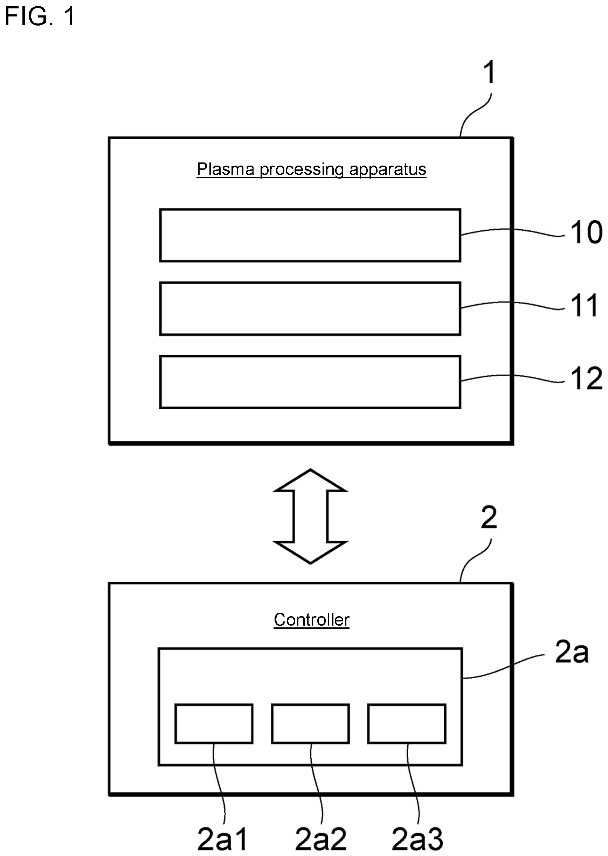

FIG. 1 is a diagram of a plasma processing system with an example structure. In one embodiment, the plasma processing system includes a plasma processing apparatus 1 and a controller 2. The plasma processing system is an example of a substrate processing system. The plasma processing apparatus 1 is an example of a substrate processing apparatus. The plasma processing apparatus 1 includes a plasma processing chamber 10, a substrate support 11, and a plasma generator 12. The plasma processing chamber 10 has a plasma processing space. The plasma processing chamber 10 has at least one gas supply port for supplying at least one process gas into the plasma processing space and at least one gas discharge port for discharging the gas from the plasma processing space. The gas supply port is connected to a gas supply 20 (described later). The gas discharge port is connected to an exhaust system 40 (described later). The substrate support 11 is located in the plasma processing space and has a substrate support surface for supporting a substrate.

The plasma generator 12 generates plasma from at least one process gas supplied into the plasma processing space. The plasma generated in the plasma processing space may be capacitively coupled plasma (CCP), inductively coupled plasma (ICP), electron cyclotron resonance (ECR) plasma, helicon wave plasma (HWP), or surface wave plasma (SWP). Various plasma generators including an alternating current (AC) plasma generator and a direct current (DC) plasma generator may be used. In one embodiment, an AC signal (AC power) used in the AC plasma generator has a frequency in a range of 100 kHz to 10 GHz. Thus, the AC signal includes a radio-frequency (RF) signal and a microwave signal. In one embodiment, the RF signal has a frequency in a range of 100 kHz to 150 MHz.

The controller 2 processes computer-executable instructions that cause the plasma processing apparatus 1 to perform various steps described in one or more embodiments of the disclosure. The controller 2 may control the components of the plasma processing apparatus 1 to perform the various steps described herein. In one embodiment, some or all of the components of the controller 2 may be included in the plasma processing apparatus 1. The controller 2 may include a processor 2a1, a storage 2a2, and a communication interface 2a3. The controller 2 is implemented by, for example, a computer 2a. The processor 2a1 may perform various control operations by loading a program from the storage 2a2 and executing the loaded program. The program may be prestored in the storage 2a2 or may be obtained through a medium as appropriate. The obtained program is stored into the storage 2a2 to be loaded from the storage 2a2 and executed by the processor 2a1. The medium may be one of various storage media readable by the computer 2a, or a communication line connected to the communication interface 2a3. The processor 2a1 may be a central processing unit (CPU). The storage 2a2 may include a random-access memory (RAM), a read-only memory (ROM), a hard disk drive (HDD), a solid-state drive (SSD), or a combination of these. The communication interface 2a3 may communicate with the plasma processing apparatus 1 through a communication line such as a local area network (LAN).

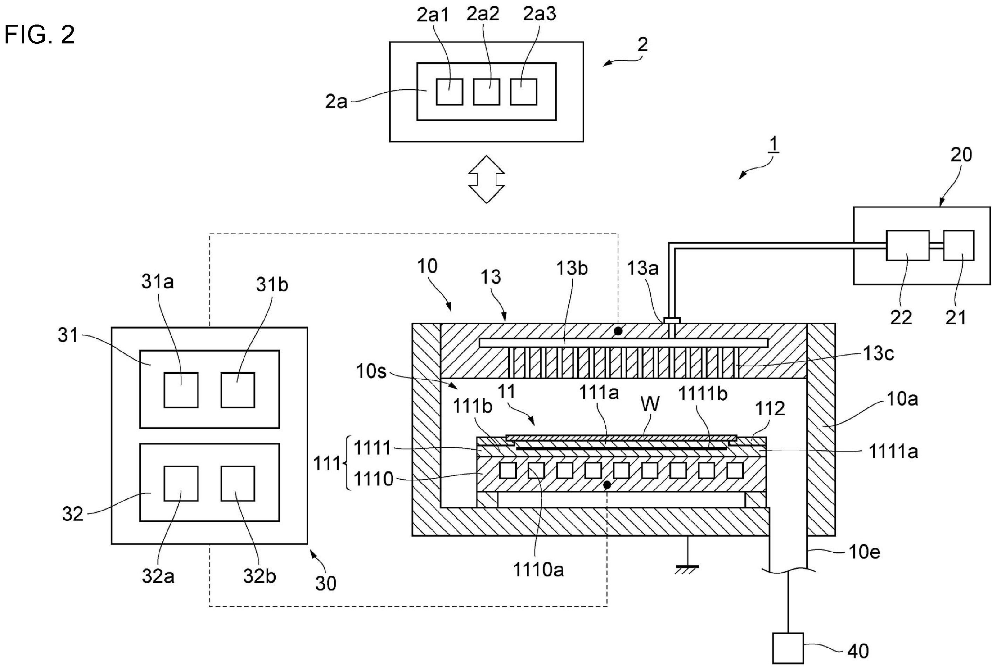

An example structure of a capacitively coupled plasma processing apparatus as an example of the plasma processing apparatus 1 will now be described. FIG. 2 is a diagram of the capacitively coupled plasma processing apparatus with an example structure.

The capacitively coupled plasma processing apparatus 1 includes the plasma processing chamber 10, the gas supply 20, a power supply 30, and the exhaust system 40. The plasma processing apparatus 1 also includes the substrate support 11 and a gas inlet unit. The gas inlet unit allows at least one process gas to be introduced into the plasma processing chamber 10. The gas inlet unit includes a shower head 13. The substrate support 11 is located in the plasma processing chamber 10. The shower head 13 is located above the substrate support 11. In one embodiment, the shower head 13 defines at least a part of the ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The shower head 13 and the substrate support 11 are electrically insulated from the housing of the plasma processing chamber 10.

The substrate support 11 includes a body 111 and a ring assembly 112. The body 111 includes a central portion 111a for supporting a substrate W and an annular portion 111b for supporting the ring assembly 112. A wafer is an example of the substrate W. The annular portion 111b of the body 111 surrounds the central portion 111a of the body 111 as viewed in plan. The substrate W is placed on the central portion 111a of the body 111. The ring assembly 112 is placed on the annular portion 111b of the body 111 to surround the substrate W on the central portion 111a of the body 111. Thus, the central portion 111a is also referred to as a substrate support surface for supporting the substrate W. The annular portion 111b is also referred to as a ring support surface for supporting the ring assembly 112.

In one embodiment, the body 111 includes a base 1110 and an electrostatic chuck (ESC) 1111. The base 1110 includes a conductive member. The conductive member in the base 1110 may serve as a lower electrode. The ESC 1111 is located on the base 1110. The ESC 1111 includes a ceramic member 1111a and an electrostatic electrode 1111b inside the ceramic member 1111a. The ceramic member 1111a includes the central portion 111a. In one embodiment, the ceramic member 1111a also includes the annular portion 111b. The annular portion 111b may be included in another member surrounding the ESC 1111, such as an annular ESC or an annular insulating member. In this case, the ring assembly 112 may be located on either the annular ESC or the annular insulating member or may be located on both the ESC 1111 and the annular insulating member. At least one RF electrode coupled to an RF power supply 31 (described later), at least one DC electrode coupled to a DC power supply 32 (described later), or both the RF electrode and the DC electrode may be located inside the ceramic member 1111a. In this case, the RF electrode(s), the DC electrode(s), or both these electrodes serve as lower electrodes. When a bias RF signal (described later) is provided to the RF electrode(s), a DC signal (described later) is provided to the DC electrode(s), or both these signals are provided to the corresponding electrodes, the electrode(s) is also referred to as a bias electrode(s). The RF electrode(s), the DC electrode(s), or both these electrodes as well as the conductive member in the base 1110 may serve as multiple lower electrodes. The electrostatic electrode 1111b may also serve as a lower electrode. Thus, the substrate support 11 includes at least one lower electrode.

The ring assembly 112 includes one or more annular members. In one embodiment, one or more annular members include one or more edge rings and at least one cover ring. The edge ring is formed from a conductive material or an insulating material. The cover ring is formed from an insulating material.

The substrate support 11 may also include a temperature control module that adjusts the temperature of at least one of the ESC 1111, the ring assembly 112, or the substrate to be a target temperature. The temperature control module may include a heater, a heat transfer medium, a channel 1110a, or a combination of these. The channel 1110a allows a heat transfer fluid such as brine or gas to flow. In one embodiment, the channel 1110a is defined in the base 1110, and one or more heaters are located in the ceramic member 1111a in the ESC 1111. The substrate support 11 may include a heat transfer gas supply to supply a heat transfer gas into a space between the back surface of the substrate W and the central portion 111a.

The shower head 13 introduces at least one process gas from the gas supply 20 into the plasma processing space 10s. The shower head 13 has at least one gas supply port 13a, at least one gas-diffusion compartment 13b, and multiple gas guides 13c. The process gas supplied to the gas supply port 13a passes through the gas-diffusion compartment 13b and is introduced into the plasma processing space 10s through the multiple gas guides 13c. The shower head 13 also includes at least one upper electrode. In addition to the shower head 13, the gas inlet unit may include one or more side gas injectors (SGIs) installed in one or more openings in the side wall 10a.

The gas supply 20 may include at least one gas source 21 and at least one flow controller 22. In one embodiment, the gas supply 20 supplies at least one process gas from the corresponding gas source 21 to the shower head 13 through the corresponding flow controller 22. The flow controller 22 may include, for example, a mass flow controller or a pressure-based flow controller. The gas supply 20 may further include at least one flow rate modulator that allows supply of at least one process gas at a modulated flow rate or in a pulsed manner.

The power supply 30 includes an RF power supply 31 that is coupled to the plasma processing chamber 10 through at least one impedance matching circuit. The RF power supply 31 provides at least one RF signal (RF power) to at least one lower electrode, to at least one upper electrode, or to both the electrodes. This causes plasma to be generated from at least one process gas supplied into the plasma processing space 10s. The RF power supply 31 may thus at least partially serve as the plasma generator 12. A bias RF signal is provided to at least one lower electrode to generate a bias potential in the substrate W, thus drawing ion components in the plasma to the substrate W.

In one embodiment, the RF power supply 31 includes a first RF generator 31a and a second RF generator 31b. The first RF generator 31a is coupled to at least one lower electrode, to at least one upper electrode, or to both the electrodes through at least one impedance matching circuit and generates a source RF signal (source RF power) for plasma generation. In one embodiment, the source RF signal has a frequency in a range of 10 to 150 MHz. In one embodiment, the first RF generator 31a may generate multiple source RF signals with different frequencies. The generated one or more source RF signals are provided to at least one lower electrode, to at least one upper electrode, or to both the electrodes.

The second RF generator 31b is coupled to at least one lower electrode through at least one impedance matching circuit and generates a bias RF signal (bias RF power). The bias RF signal may have a frequency that is the same as or different from the frequency of the source RF signal. In one embodiment, the bias RF signal has a lower frequency than the source RF signal. In one embodiment, the bias RF signal has a frequency in a range of 100 kHz to 60 MHz. In one embodiment, the second RF generator 31b may generate multiple bias RF signals with different frequencies. The generated one or more bias RF signals are provided to at least one lower electrode. In various embodiments, at least one of the source RF signal or the bias RF signal may be pulsed.

The power supply 30 may also include a DC power supply 32 coupled to the plasma processing chamber 10. The DC power supply 32 includes a first DC generator 32a and a second DC generator 32b. In one embodiment, the first DC generator 32a is coupled to at least one lower electrode and generates a first DC signal. The generated first DC signal is applied to at least one lower electrode. In one embodiment, the second DC generator 32b is coupled to at least one upper electrode and generates a second DC signal. The generated second DC signal is applied to at least one upper electrode.

In various embodiments, the first DC signal and the second DC signal may be pulsed. In this case, a sequence of voltage pulses is applied to at least one lower electrode, to at least one upper electrode, or to both the electrodes. The voltage pulses may have a rectangular, trapezoidal, or triangular pulse waveform, or a combination of these pulse waveforms. In one embodiment, a waveform generator for generating a sequence of voltage pulses based on DC signals is coupled between the first DC generator 32a and at least one lower electrode. Thus, the first DC generator 32a and the waveform generator are included in a voltage pulse generator. When the second DC generator 32b and the waveform generator are included in a voltage pulse generator, the voltage pulse generator is coupled to at least one upper electrode. The voltage pulses may have positive polarity or negative polarity. The sequence of voltage pulses may include one or more positive voltage pulses and one or more negative voltage pulses within one cycle. The power supply 30 may include the first DC generator 32a and the second DC generator 32b in addition to the RF power supply 31, or the first DC generator 32a may replace the second RF generator 31b.

The exhaust system 40 is connectable to, for example, a gas discharge port 10e in the bottom of the plasma processing chamber 10. The exhaust system 40 may include a pressure control valve and a vacuum pump. The pressure control valve regulates the pressure in the plasma processing space 10s. The vacuum pump may include a turbomolecular pump, a dry pump, or a combination of these.

### Example Structure of ESC

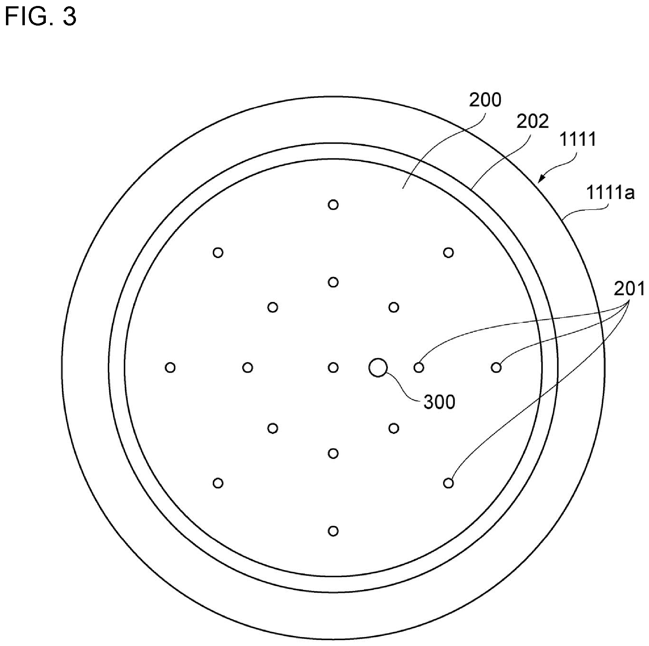

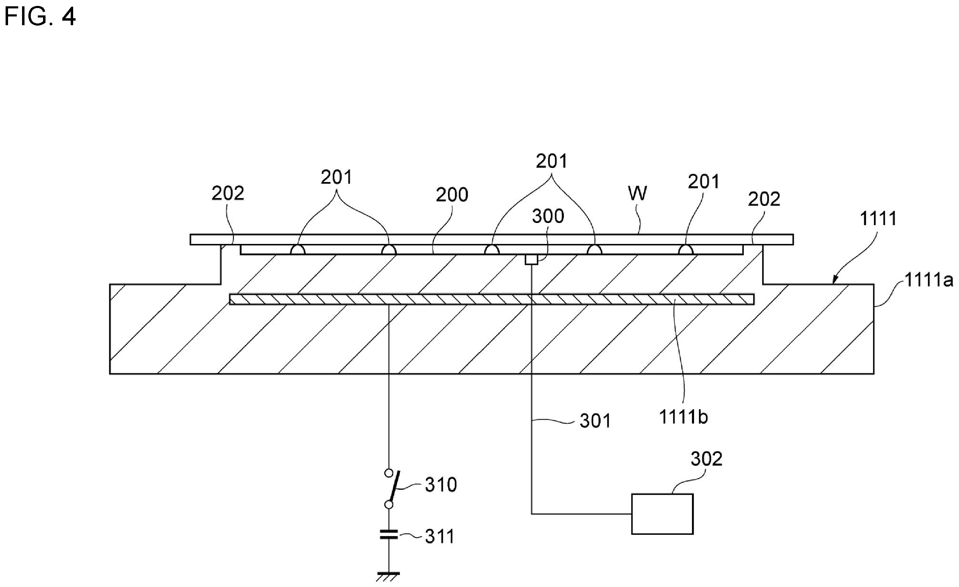

FIGs. 3 and 4 are diagrams of the ESC 1111 with an example structure as viewed from above. FIG. 3 is a diagram of the ESC 1111 as viewed from above, showing an example structure. In one embodiment, the ESC 1111 may include the ceramic member 1111a and the electrostatic electrode 1111b in the ceramic member 111la. The ceramic member 1111a may be an example of a dielectric member.

The ceramic member 1111a may be substantially cylindrical. The ceramic member 1111a may include an upper surface 200, multiple projections 201, and a seal band 202.

The upper surface 200 may be a circular horizontal surface. The upper surface 200 may be centered at the central axis of the ceramic member 1111a.

The multiple projections 201 may support the back surface of the substrate W when the substrate is electrostatically clamped by the ESC 1111. The multiple projections 201 may be arranged on the upper surface 200. Each projection 201 may project upward from the upper surface 200. Each projection 201 may have a substantially hemispherical shape that is highest at the center. The projections 201 may be integral with or separate from the upper surface 200. The projections 201 may be formed from a material different from the material of the upper surface 200.

Each projection 201 may have a height in a range of 5 to 50 µm. Each projection 201 may have a width (outer diameter) in a range of 0.1 to 3 mm.

The projections 201 may be arranged at intervals (pitch) in a range of 3 to 30 mm. The multiple projections 201 may be evenly distributed on the upper surface 200. The multiple projections 201 may be arranged concentrically with, radially from, or in a grid pattern about the center of the upper surface 200.

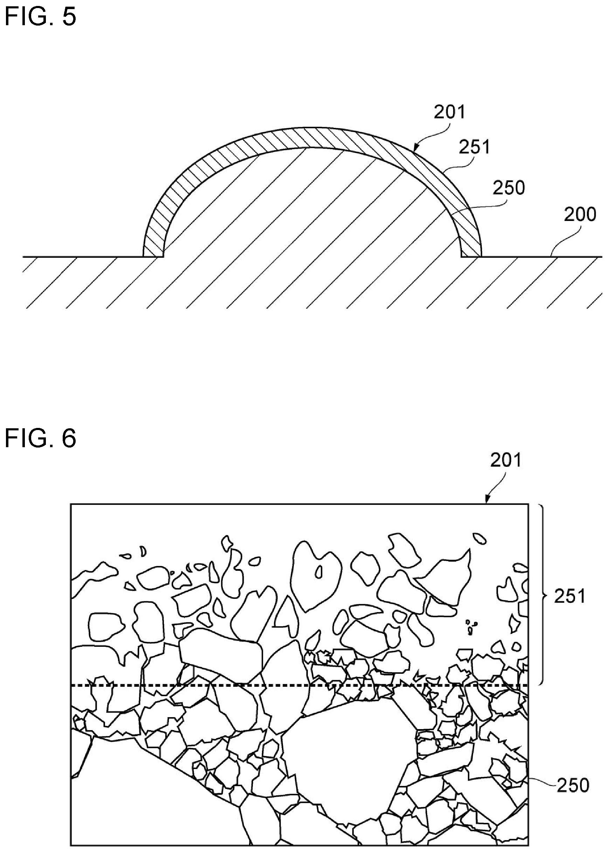

FIG. 5 is a diagram of a projection 201 with an example structure. FIG. 6 is a diagram of the projection 201 showing an example structure. The projection 201 may include a crystalline base 250 and an amorphous surface layer 251 on the base 250.

The base 250 may be formed from crystalline alumina (Al₂O₃). The crystal grains in the base 250 may have an average grain diameter in a range of 0.5 to 30 µm, or more specifically, 2 to 15 µm. The average grain diameter D of grains assumed to be circular can be calculated from an area C per circular grain obtained as a specific area A divided by the number of grains B in the area A (C = A/B).

The surface layer 251 may be formed from amorphous alumina. The surface layer 251 may have a thickness in a range of 0.1 to 20 µm. The surface layer 251 may be a laser-processed layer formed by applying a laser beam. The surface layer 251 may have marks resulting from laser beam application. The marks resulting from laser beam application may be marks of the material melted by a laser beam and subsequently solidified. The surface layer 251 may include a portion in which amorphous materials and crystalline materials are mixed near the base 250.

The surface layer 251 of each projection 201 may have a thermal conductivity equal to or lower than the thermal conductivity of the base 250.

As shown in FIGs. 3 and 4, the seal band 202 may be annularly located along the outer periphery of the upper surface 200 and project upward from the upper surface 200. When the substrate W is electrostatically clamped by the ESC 1111, the seal band 202 may be in contact with the outer periphery of the back surface of the substrate W. The seal band 202 may have a height that is the same as, greater than, or smaller than the height of the projections 201. The seal band 202 may be an example of the projection. In other words, the seal band 202 may include a base 250 and a surface layer 251, similarly to the projections 201 described above.

The upper surface 200 may have a gas outlet 300 through which a heat transfer gas flows out. As shown in FIG. 4, the gas outlet 300 may be connected to a heat transfer gas supply 302 through a gas channel 301. The gas channel 301 may extend through the substrate support 11. The heat transfer gas supply 302 may be external to the chamber 10. The first upper surface 200 may have one or more gas outlets 300. The heat transfer gas may include a helium gas.

The electrostatic electrode 1111b may be coupled to a DC power supply 311 through a switch 310. The DC power supply 311 applies a DC voltage to the electrostatic electrode 1111b, generating an electrostatic attraction (Coulomb force) between the ceramic member 1111a and the substrate W. The substrate W may be attracted to the ceramic member 1111a by the electrostatic attraction, and may be clamped and held on the ceramic member 1111a.

### Example Method for Manufacturing ESC

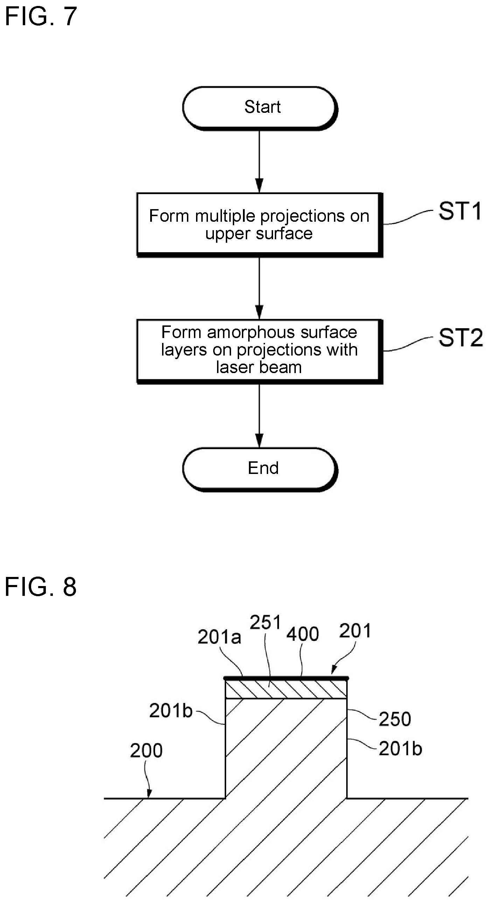

FIG. 7 is a flowchart of an example method for manufacturing an ESC (hereafter also referred to as the manufacturing method). The manufacturing method may include step ST1 for forming the multiple projections projecting upward from the upper surface 200 of the ceramic member 1111a and step ST2 for forming amorphous surface layers on the projections by applying a laser beam to the projections.

In step ST1, the multiple projections may be formed by machining, by laser processing, or by both machining and laser processing the surface of the ceramic member 1111a. The projections may also be formed by bonding pre-molded projections to the surface of the ceramic member 1111a. The ceramic member 1111a may be a ceramic member included in a used ESC that has been used in the plasma processing apparatus 1. The ceramic member 1111a may be a ceramic member included in an ESC that has been removed from the plasma processing apparatus 1. The manufacturing method may include a step for removing a used ESC from the plasma processing apparatus 1. When laser processing is used, portions of the upper surface of the ceramic member 1111a, or for example, portions to be other than projections, may be cut with a laser beam to form the projections.

In step ST2, the laser light source may emit ultraviolet light or infrared light. The amorphous surface layer 251 may have a thickness in a range of 0.1 to 20 µm. The amorphous surface layer 251 may have a thickness in a range of 0.1 to 10 µm. The amorphous surface layer 251 may contain a plasma-resistant ceramic material. The amorphous surface layer 251 may contain amorphous alumina.

### Example Plasma Processing Method

A plasma processing method implementable in the plasma processing apparatus 1 includes etching a film on the substrate W with plasma. In one embodiment, the plasma processing method is implementable with the controller 2 in the plasma processing apparatus 1.

As shown in FIG. 2, the substrate W is first loaded into the chamber 10 and placed onto the substrate support 11. As shown in FIG. 4, the substrate W is clamped and held by the ESC 1111. In this state, the substrate W is on the ceramic member 1111a, and the back surface of the substrate W is in contact with the projections 201 and the seal band 202. A DC voltage is applied to the electrostatic electrode 1111b to generate an electrostatic attraction between the ESC 1111 and the substrate W, causing the ESC 1111 to clamp the substrate W.

In the substrate support 11 shown in FIG. 2, a refrigerant is supplied to the channel 1110a to adjust the temperatures of the ESC 1111 and the substrate W held by the ESC 1111 to be predetermined temperatures.

A heat transfer gas is supplied from the heat transfer gas supply 302 shown in FIG. 4 to the gas outlet 300, and then into a space between the substrate W and the upper surface 200 through the gas outlet 300. The heat transfer gas adjusts the temperature of the substrate W from the back surface of the substrate W.

Subsequently, a process gas is supplied from the gas supply 20 shown in FIG. 2 to the shower head 13, and then into the plasma processing space 10s from the shower head 13. The supplied process gas contains a gas for generating an active species that is to be used for etching the substrate W.

One or more RF signals are provided from the RF power supply 31 to the upper electrode, to the lower electrode, or to both the electrodes. The atmosphere in the plasma processing space 10s may be discharged through the gas discharge port 10e to decompress the plasma processing space 10s. This generates plasma above the substrate support 11 in the plasma processing space 10s to etch the substrate W.

In the present exemplary embodiment, the ceramic member 1111a in the ESC 1111 includes the upper surface 200 and the projections 201 projecting upward from the upper surface 200 to support the substrate W. Each projection 201 includes the crystalline base 250 and the amorphous surface layer 251 on the base 250. This structure reduces scratches on the back surface of the substrate W held by the ESC 1111.

In crystalline projections sliding against the back surface of the substrate W under a high surface pressure, stress is concentrated on the boundaries of crystal grains, causing separation or detachment of crystal grains. Such crystal grains and pointed portions of the substrate support surface resulting from detached crystal grains may scratch the back surface of the substrate W. The amorphous surface layers 251 on the projections 201, as in the present exemplary structure, reduce separation and detachment of crystalline grains. This can reduce scratches on the back surface of the substrate W resulting from contact with the projections. In addition, the surface layers 251 on the projections 201 being cut produce very fine subnano-sized particles that serve as lubricating particles. This lowers the coefficient of friction between the substrate W and the projections 201, reducing scratches on the back surface of the substrate W. In addition, reduced separation and detachment of crystal grains reduces generation of crystal particles.

### Examples

A laser beam was applied to the surface of crystalline alumina to capture images of the surface with an electron backscatter diffraction (EBDS) analyzer. FIG. 6 is a schematic diagram of alumina imaged with an EBDS analyzer, showing an example structure. As shown in FIG. 6, amorphous (without crystal grains) alumina (the surface layer 251) was formed on crystalline (with crystal grains) alumina (the base 250) by applying a laser beam.

Scratch tests were performed on crystalline alumina and amorphous alumina. The scratch tests were performed as described below. An indenter (R = 200 µm) in a scratch tester was placed in contact with a specimen. The indenter was then moved in one direction while the contact load was being increased, and images were captured during the process. The load was increased continuously from 0 to 40 N. Based on the width of the scratch resulting from the indenter slid against the specimen and the load on the indenter, the surface pressure applied to the specimen was calculated, and the surfaces of the crystalline specimen and the amorphous specimen under the same surface pressure were observed.

In crystalline alumina, separation of crystal grains and numerous crushed fine particles with sharp edges were observed. However, in amorphous alumina, no particle separation or crushed particles were observed on the surface.

Although the ESC 1111 is used in the capacitively coupled plasma apparatus in the above embodiments, the ESC 1111 may be used in a plasma system of another type. The ESC 1111 may be used in another substrate processing apparatus other than the plasma processing apparatus.

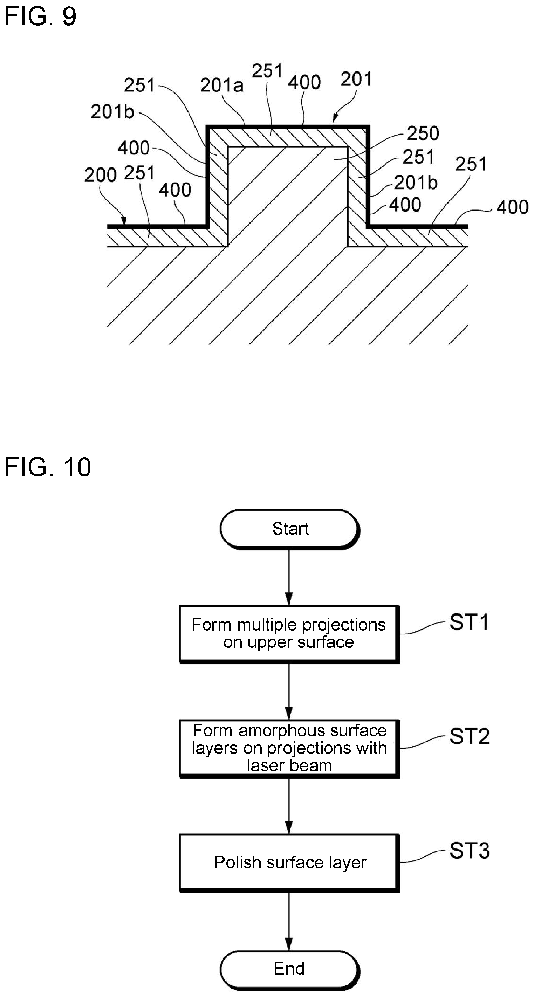

In the above embodiments, the surface layer 251 of each projection 201 may have a polished surface 400 with a surface roughness Ra less than or equal to 0.05 µm as shown in FIG. 8. Each projection 201 may be cylindrical. The amorphous surface layer 251 may be formed on an upper surface 201a of the projection 201. As shown in FIG. 9, the surface layer 251 and its polished surface 400 may be formed on the upper surface 201a and a side surface 201b of the projection 201. The amorphous surface layer 251 and the polished surface 400 may also be formed on the upper surface 200 of the ceramic member 1111a.

In this case, the above method for manufacturing an ESC may include step ST3 for polishing the surface layer 251, following step ST2 for forming the amorphous surface layers as shown in FIG. 10. Step ST3 forms the polished surface 400. In step ST3, the surface layer 251 may be polished by blasting to form the polished surface 400. Elastic abrasives may be used in blasting. In the present embodiment, irregularities on the surface layer 251 resulting from laser processing are smoothed. This can reduce fluctuations in the substrate temperature due to changes in the contact area of the substrate with the projections 201 supporting the wafer, and also reduce dust generated from the surface layer due to frictions with the substrate or application of plasma.

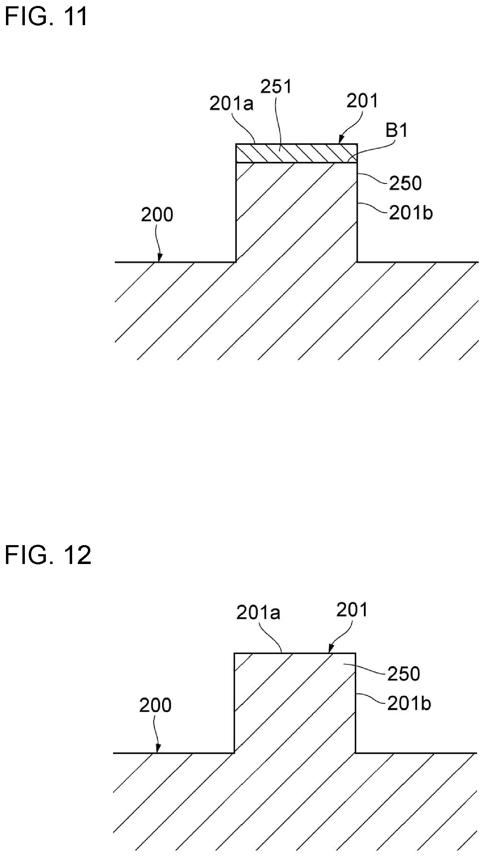

In the above embodiments, a boundary B1 between the crystalline base 250 and the amorphous surface layer 251 may be exposed on the side surface 201b of the projection 201, as shown in FIG. 11, without being exposed on the upper surface 201a of the projection 201.

In such a case, the projections 201 are formed by blasting in step ST1 for forming the projections in the above method for manufacturing an ESC as shown in FIG. 12. In step ST2 for forming the amorphous surface layers, a laser beam is applied to the upper surface 201a of each projection 201. The amorphous surface layer 251 is thus formed on the upper surface 201a of the projection 201 as shown in FIG. 11.

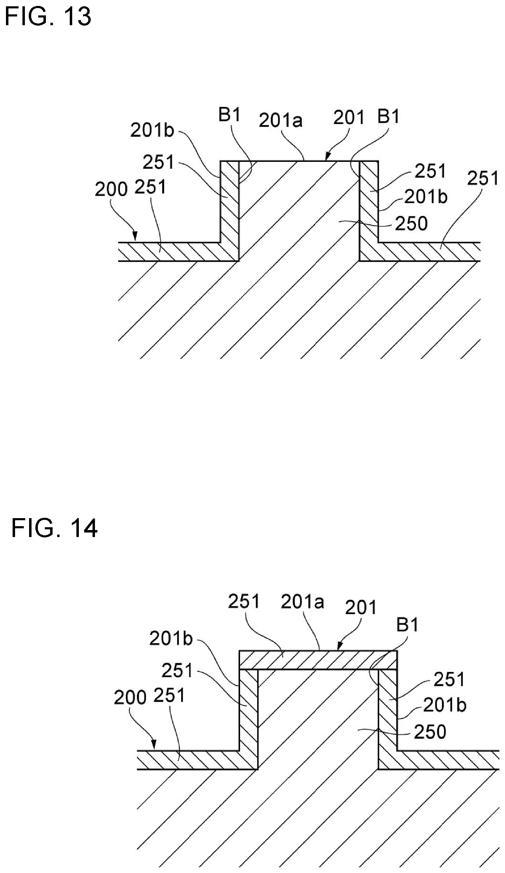

In some embodiments, the projections 201 may be formed by laser processing in step ST1 for forming the projections in the above method for manufacturing an ESC. In this step, or in subsequent step ST2 for forming the amorphous surface layers, a laser beam is applied to the projections 201. This forms the amorphous surface layer 251 on the side surface 201b of each projection 201 as shown in FIG. 13. In this state, the boundary B1 between the crystalline base 250 and the amorphous surface layer 251 is exposed on the upper surface 201a. Subsequently, a laser beam is applied to the upper surface 201a of the projection 201. This forms the amorphous surface layer 251 on the upper surface 201a of the projection 201 as shown in FIG. 14. The boundary B1 between the crystalline base 250 and the amorphous surface layer 251 is thus not exposed on the upper surface 201a of the projection 201 but is exposed on the side surface 201b of the projection 201. This structure can reduce the likelihood that the boundary B1 serves as a crack interface and grains separating from the crack interface accumulate on the substrate, thus reducing the scratches on the back surface of the substrate.

In the above embodiments, the surface layer 251 may have a depth in a range of 100 to 500 nm from the surface and a hardness (nanoindenter value) in a range of 22 to 27 GPa when measured with a nanoindenter method. The nanoindenter value of the surface layer 251 may be greater than the nanoindenter value of silicon monocrystal and less than the nanoindenter value of alumina ceramics.

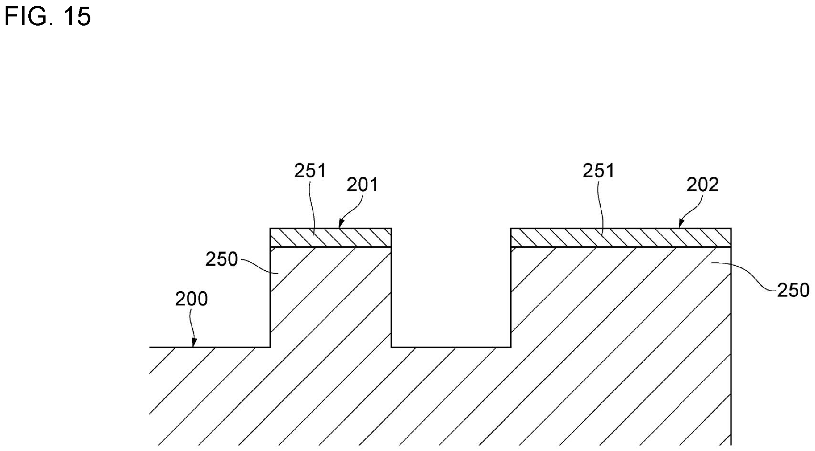

As shown in FIG. 15, in the above embodiments, the seal band 202 may include the crystalline base 250 and the amorphous surface layer 251, similarly to the projections 201 described above. The amorphous surface layer 251 may be formed on the upper surface of the seal band 202 or on the upper surface and the side surface of the seal band 202.

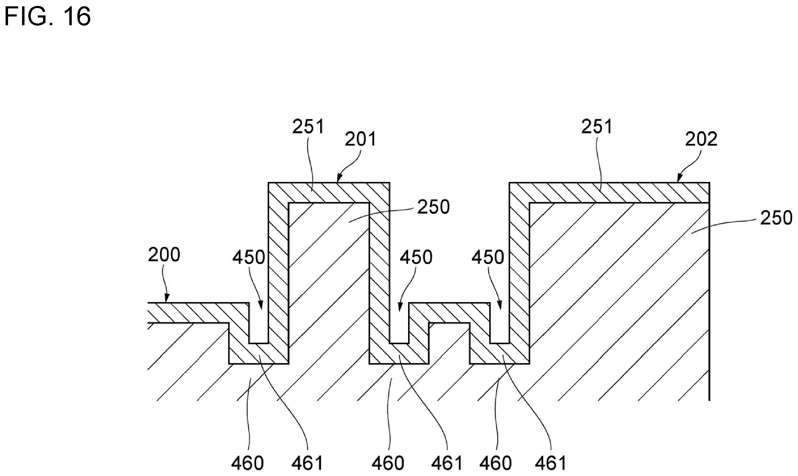

As shown in FIG. 16, the ceramic member 1111a may further include grooves 450 surrounding the projections 201 and the seal band 202. Each groove 450 may be annularly located to surround the corresponding projection 201. A groove 450 may be annularly located inward from the annular seal band 202. Each groove 450 may include a crystalline groove base 460 and an amorphous groove surface layer 461 on the groove base 460. The groove surface layer 461 may be formed by applying a laser beam, similarly to the projections 201 described above.

The embodiments of the disclosure further include the aspects described below.

### Appendix 1

An electrostatic chuck for holding a substrate, the electrostatic chuck comprising:
a dielectric member; and
an electrode in the dielectric member,
wherein the dielectric member includes
   an upper surface, and
   a plurality of projections projecting upward from the upper surface, the plurality of projections being configured to support a substrate, each of the plurality of projections including a crystalline base and an amorphous surface layer on the crystalline base.

### Appendix 2

The electrostatic chuck according to appendix 1, wherein
the amorphous surface layer has a thickness in a range of 0.1 to 20 µm.

### Appendix 3

The electrostatic chuck according to appendix 1 or appendix 2, wherein
the amorphous surface layer has a thermal conductivity equal to or lower than a thermal conductivity of the crystalline base.

### Appendix 4

The electrostatic chuck according to any one of appendixes 1 to 3, wherein
the amorphous surface layer comprises amorphous alumina.

### Appendix 5

The electrostatic chuck according to any one of appendixes 1 to 4, wherein
the plurality of projections have marks from laser beam application.

### Appendix 6

A method for manufacturing an electrostatic chuck, the method comprising:
(a) forming a plurality of projections projecting upward from an upper surface of a dielectric member, the plurality of projections being crystalline; and
(b) forming an amorphous surface layer on each of the plurality of projections by applying a laser beam to the plurality of projections.

### Appendix 7

The method according to appendix 6, wherein
the amorphous surface layer has a thickness in a range of 0.1 to 20 µm.

### Appendix 8

The method according to appendix 6 or appendix 7, wherein
the amorphous surface layer has a lower thermal conductivity than a base included in each of the plurality of projections.

### Appendix 9

The method according to any one of appendixes 6 to 8, wherein
the amorphous surface layer comprises amorphous alumina.

### Appendix 10

A method for manufacturing an electrostatic chuck, the method comprising:
(a) forming, on an upper surface of a dielectric member included in a (used) electrostatic chuck used in plasma processing, a plurality of projections projecting upward from the upper surface, the plurality of projections being crystalline; and
(b) forming an amorphous surface layer on each of the plurality of projections by applying a laser beam to the plurality of projections.

### Appendix 11

The method according to appendix 10, wherein
the amorphous surface layer has a thickness in a range of 0.1 to 20 µm.

### Appendix 12

The method according to appendix 10 or appendix 11, wherein
the amorphous surface layer has a thermal conductivity equal to or lower than a thermal conductivity of a base included in each of the plurality of projections.

### Appendix 13

The method according to any one of appendixes 10 to 12, wherein
the amorphous surface layer comprises amorphous alumina.

### Appendix 14

The electrostatic chuck according to any one of appendixes 1 to 5, wherein
the amorphous surface layer includes a polished surface with a surface roughness Ra less than or equal to 0.05 µm.

### Appendix 15

The electrostatic chuck according to any one of appendixes 1 to 5 and 14, wherein
each of the plurality of projections includes an upper surface and a side surface, and
a boundary between the crystalline base and the amorphous surface layer is exposed on the side surface of each of the plurality of projections without being exposed on the upper surface of the projection.

### Appendix 16

The electrostatic chuck according to any one of appendixes 1 to 5, 14, and 15, wherein
the amorphous surface layer has a depth in a range of 100 to 500 nm from a surface and a hardness in a range of 22 to 27 GPa when measured with a nanoindenter method.

### Appendix 17

The electrostatic chuck according to any one of appendixes 1 to 5 and 14 to 16, wherein
each of the plurality of projections includes a seal band configured to support an outer periphery of the substrate.

### Appendix 18

The electrostatic chuck according to any one of appendixes 1 to 5 and 14 to 17, wherein
the dielectric member further includes grooves surrounding respective projections of the plurality of projections, and
each of the grooves includes a crystalline groove base and an amorphous groove surface layer on the crystalline groove base.

### Appendix 19

The method according to any one of appendixes 6 to 13, further comprising:
(c) polishing the amorphous surface layer.

### Appendix 20

The method according to any one of appendixes 6 to 13 and 19, wherein
(a) includes forming the plurality of projections by laser processing, and
(b) includes forming the amorphous surface layer on a side surface of each of the plurality of projections and subsequently the amorphous surface layer on an upper surface of each of the plurality of projections by applying a laser beam.

### Appendix 21

The method according to any one of appendixes 6 to 13 and 19, wherein
(a) includes forming the plurality of projections by blasting, and
(b) includes forming the amorphous surface layer on an upper surface of each of the plurality of projections by applying a laser beam.

The above embodiments are mere examples described for illustrative purposes and are not intended to limit the scope of the disclosure. The embodiments may be modified in various ways without departing from the spirit and scope of the disclosure. For example, one or more components in one embodiment may be added to the structure according to another embodiment. One or more components in one embodiment may be replaced with the corresponding one or more components in another embodiment.

### REFERENCE SIGNS LIST

1 Plasma processing apparatus
10 Chamber
11 Substrate support
1111 Electrostatic chuck (ESC)
1111a Ceramic member
1111b Electrostatic electrode
200 Upper surface
201 Projection
202 Seal band
250 Base
251 Surface layer
W Substrate

## Claims

1. An electrostatic chuck for holding a substrate, the electrostatic chuck comprising:
a dielectric member; and
an electrode in the dielectric member,
wherein the dielectric member includes
an upper surface, and
a plurality of projections projecting upward from the upper surface, the plurality of projections being configured to support a substrate, each of the plurality of projections including a crystalline base and an amorphous surface layer on the crystalline base.

2. The electrostatic chuck according to claim 1, wherein
the amorphous surface layer has a thickness in a range of 0.1 to 20 µm.

3. The electrostatic chuck according to claim 1, wherein
the amorphous surface layer has a thermal conductivity equal to or lower than a thermal conductivity of the crystalline base.

4. The electrostatic chuck according to claim 1, wherein
the amorphous surface layer comprises amorphous alumina.

5. The electrostatic chuck according to claim 1, wherein
the plurality of projections have marks from laser beam application.

6. A method for manufacturing an electrostatic chuck, the method comprising:
(a) forming a plurality of projections projecting upward from an upper surface of a dielectric member, the plurality of projections being crystalline; and
(b) forming an amorphous surface layer on each of the plurality of projections by applying a laser beam to the plurality of projections.

7. The method according to claim 6, wherein
the amorphous surface layer has a thickness in a range of 0.1 to 20 µm.

8. The method according to claim 6, wherein
the amorphous surface layer has a thermal conductivity equal to or lower than a thermal conductivity of a base included in each of the plurality of projections.

9. The method according to claim 6, wherein
the amorphous surface layer comprises amorphous alumina.

10. A method for manufacturing an electrostatic chuck, the method comprising:
(a) forming, on an upper surface of a dielectric member included in an electrostatic chuck used in plasma processing, a plurality of projections projecting upward from the upper surface, the plurality of projections being crystalline; and
(b) forming an amorphous surface layer on each of the plurality of projections by applying a laser beam to the plurality of projections.

11. The method according to claim 10, wherein
the amorphous surface layer has a thickness in a range of 0.1 to 20 µm.

12. The method according to claim 10, wherein
the amorphous surface layer has a lower thermal conductivity than a base included in each of the plurality of projections.

13. The method according to claim 10, wherein
the amorphous surface layer comprises amorphous alumina.

14. The electrostatic chuck according to claim 1, wherein
the amorphous surface layer includes a polished surface with a surface roughness Ra less than or equal to 0.05 µm.

15. The electrostatic chuck according to claim 1, wherein
each of the plurality of projections includes an upper surface and a side surface, and
a boundary between the crystalline base and the amorphous surface layer is exposed on the side surface of each of the plurality of projections without being exposed on the upper surface of the projection.

16. The electrostatic chuck according to claim 1, wherein
the amorphous surface layer has a depth in a range of 100 to 500 nm from a surface and a hardness in a range of 22 to 27 GPa when measured with a nanoindenter method.

17. The electrostatic chuck according to claim 1, wherein
each of the plurality of projections includes a seal band configured to support an outer periphery of the substrate.

18. The electrostatic chuck according to claim 1, wherein
the dielectric member further includes grooves surrounding respective projections of the plurality of projections, and
each of the grooves includes a crystalline groove base and an amorphous groove surface layer on the crystalline groove base.

19. The method according to claim 6 or claim 10, further comprising:
(c) polishing the amorphous surface layer.

20. The method according to claim 6 or claim 10, wherein
(a) includes forming the plurality of projections by laser processing, and
(b) includes forming the amorphous surface layer on a side surface of each of the plurality of projections and subsequently the amorphous surface layer on an upper surface of each of the plurality of projections by applying a laser beam.

21. The method according to claim 6 or claim 10, wherein
(a) includes forming the plurality of projections by blasting, and
(b) includes forming the amorphous surface layer on an upper surface of each of the plurality of projections by applying a laser beam.
